# EUROPEAN PATENT APPLICATION

(11) **EP 3 121 848 A1**
(43) Date of publication of application: **25.01.2017**
(21) Application number: 15765813.9
(22) Date of filing: 03.02.2015
(51) Int. Cl.: H01L 23/36, H01L 25/07, H01L 25/18, H05K 7/20

(54) **POWER CONVERSION DEVICE**

(30) Priority: 18.03.2014 JP 2014055208
(71) Applicant: Fuji Electric Co., Ltd., Kawasaki-shi, Kanagawa 210-9530 (JP)
(72) Inventor: ITO, Takafumi, Kawasaki-shi Kanagawa 2109530 (JP); YAMASAKI, Takahiro, Kawasaki-shi Kanagawa 2109530 (JP); ADACHI, Taketo, Kawasaki-shi Kanagawa 2109530 (JP)
(74) Representative: Appelt, Christian W.
(86) International application number: PCT/JP2015/052949
(87) International publication number: WO 2015/141305

(57) **Abstract**

An electric power conversion device includes: a frame 20 which is formed of a highly heat-conductive material and in which a heat sink is arranged that dissipates heat of a semiconductor element H stored inside an device main body 1 and openings 25a, 26a are formed that causes external air to pass through between fins 32 included in the heat sink. The frame 20 includes a covering portion 24 that covers the heat sink in a state in which the frame 20 is thermally connected to each fin 32 by inserting a tip portion of each fin 32 into a groove portion 24a formed in covering portion 24.

## Description

### Field

The present invention relates to an electric power conversion device.

### Background

Conventionally, an electric power conversion device is used to control such as, for example, an elevating machine and an air conditioner. In this sort of electric power conversion device, a semiconductor element which is a main component is stored in an device main body and a heat sink to cool down the semiconductor element is provided. The heat sink is formed by, for example, caulking or the like by using a material having good thermal conductivity performance. The circumference of the heat sink is surrounded by a frame manufactured by die-casting. The frame forms a part of the device main body. An opening to cause external air to pass through is formed between fins that form the heat sink. The semiconductor element is also thermally connected to the frame, and the heat is also dissipated from the frame, so that cooling capacity is improved by enlarging a heat dissipation area (for example, see Patent Literature 1).

### Citation List

### Patent Literature

Patent Literature 1: Japanese Patent No. 4936019 Summary

### Technical Problem

By the way, in the electric power conversion device as described above, the cooling efficiency of the heat sink is required to be improved at all times so as to deal with downsizing of the device and increase of the amount of heat generation of the semiconductor element.

In view of the above situation, an object of the present invention is to provide an electric power conversion device that can improve the cooling efficiency. Solution to Problem

To achieve the above-described object, an electric power conversion device according to the present invention includes: a frame which is formed of a highly heat-conductive material. The frame is provided with a heat sink that dissipates heat of a semiconductor element stored inside an device main body. The frame is provided with an opening that causes external air to pass through between fins included in the heat sink. The frame includes a covering portion that covers the heat sink in a state in which the frame is thermally connected to each fin by inserting a tip portion of each fin into a groove portion formed in the covering portion.

In the electric power conversion device according to the present invention, the covering portion includes at least a guide portion which is formed in a manner in which a width of the guide portion in a direction perpendicular to a longitudinal direction of the groove portion gradually reduces toward a base end portion of the fin between groove portions adjacent to each other and which has an inclined surface continuing to an inner wall surface of the groove portion.

In the electric power conversion device according to the present invention, the fin includes an inclined guide surface formed by gradually reducing a thickness of the fin toward a tip surface of the fin.

In the electric power conversion device according to the present invention, the frame has a surface with unevenness.

In the electric power conversion device according to the present invention, the semiconductor element is a wide band gap semiconductor element composed mainly of at least one material selected from silicon carbide, gallium nitride, and diamond.

### Advantageous Effects of Invention

According to the present invention, the frame is formed of the highly heat-conductive material and a covering portion covers the heat sink in a state in which the covering portion is thermally connected to each fin by inserting a tip portion of each fin into a groove portion, so that the entire frame plays a role of a heat dissipation member. Thereby, an effect is achieved where the cooling efficiency can be improved by an increase of the heat dissipation area.

### Brief Description of Drawings

FIG. 1 is a perspective view schematically illustrating an electric power conversion device which is an embodiment of the present invention.
FIG. 2 is a cross-sectional view illustrating an enlarged main portion of the electric power conversion device illustrated in FIG. 1.
FIG. 3 is a perspective view schematically illustrating a modified example of the electric power conversion device which is the embodiment of the present invention.
FIG. 4 is a cross-sectional view illustrating an enlarged main portion of the electric power conversion device illustrated in FIG. 3.

### Description of Embodiment

Hereinafter, a preferred embodiment of an electric power conversion device according to an embodiment of the present invention will be described in detail.

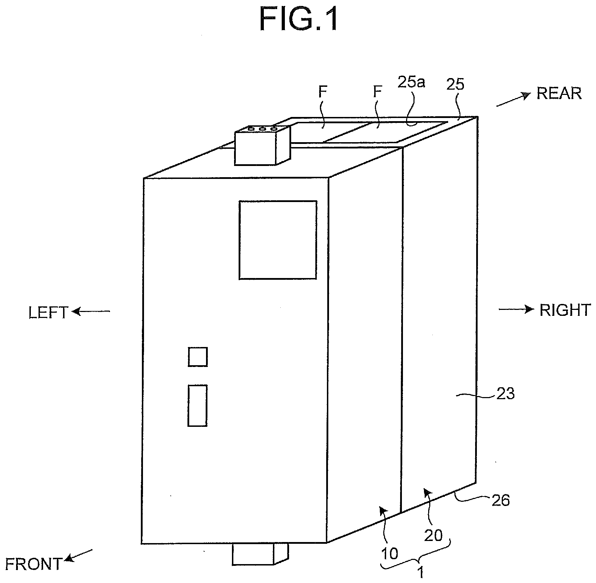

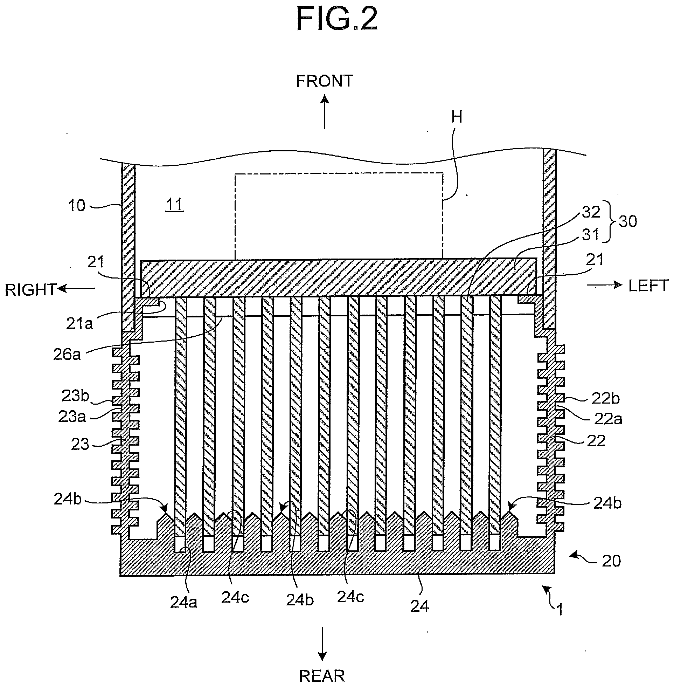

FIG. 1 is a perspective view schematically illustrating an electric power conversion device which is the embodiment of the present invention. FIG. 2 is a cross-sectional view illustrating an enlarged main portion of the electric power conversion device illustrated in FIG. 1. The electric power conversion device exemplified here includes an device main body 1.

The device main body 1 is configured to include a storage main body 10 and a frame 20. The storage main body 10 is a box body having a rectangular parallelepiped shape with an open rear surface. The storage main body 10 is connected to the frame 20 so as to cover the front area of the frame 20.

The storage main body 10 is formed of, for example, a resin material. A storage space 11 for storing various control devices is formed between the storage main body 10 and the frame 20.

The frame 20 is formed by, for example, extrusion molding of a highly heat-conductive material having good thermal conductivity such as, for example, aluminum.

The frame 20 is a cylindrical body where a front surface portion 21 (see FIG. 2) which is covered by the storage main body 10 and which faces inside the storage main body 10, a pair of left and right side surface portions 22 and 23 which extends from both left and right end portions of the front surface portion 21 toward the rear, and a covering portion 24 which connects respective rear end portions of the side surface portions 22 and 23 are integrally formed, so that ventilating openings 25a and 26a through which external air passes are formed in an upper surface 25 and a lower surface 26.

The ventilating opening 25a in the upper surface 25 is closed by arranging a plurality of (in the example in FIG. 1, two) blower fans F supported by the frame 20. Here, when the blower fan F is driven, the blower fan F introduces external air from the ventilating opening 26a formed in the lower surface 26 into the inside of the frame 20 and transmits the air that passes through the inside of the frame 20 to the outside through the ventilating opening 25a formed in the upper surface 25. The ventilating opening 26a in the lower surface 26 is appropriately covered by a filter or the like not illustrated in the drawings.

As illustrated in FIG. 2, a fin unit 30 which is a heat sink is arranged to the frame 20.

The fin unit 30 is formed of a highly heat-conductive material having good thermal conductivity such as, for example, aluminum. The fin unit 30 includes a base portion 31 and a plurality of fins 32.

The base portion 31 has a substantially flat plate shape and is attached to the front surface portion 21 of the frame 20. A semiconductor element H such as, for example, an IGBT (Insulated Gate Bipolar Transistor), a MOS-FET (Metal Oxide Semiconductor-Field Effect Transistor), and a diode is thermally connected to the front surface of the base portion 31. Here, the semiconductor element H may be not only a Si-based semiconductor element, but also a wide band gap semiconductor element composed mainly of at least one material selected from silicon carbide, gallium nitride, and diamond.

Each of the plurality of fins 32 has a thin flat plate shape. The fins 32 are arranged in an upright posture at predetermined intervals so that the fins 32 are arranged along the rear surface of the base portion 31 in the horizontal direction in a form in which the fins 32 penetrate an attaching opening 21a formed in the front surface portion 21 of the frame 20. The fins 32 are arranged by performing caulking processing in a state in which base end portions of the fins 32 are inserted into recessed portions formed in the base portion 31 not illustrated in the drawings.

On the left side surface portion 22 of the frame 20, unevenness is formed by alternately forming recessed portions 22a and protruded portions 22b on a left surface that is an outer surface and on a right surface that is an inner surface. Further, on the right side surface portion 23 of the frame 20, unevenness is formed by alternately forming recessed portions 23a and protruded portions 23b on a right surface that is an outer surface and on a left surface that is an inner surface.

The covering portion 24 of the frame 20 forms a rear surface portion of the frame 20. A plurality of groove portions 24a is formed in a front surface of the covering portion 24. The groove portions 24a extend in the front surface of the covering portion 24 in the vertical direction. The groove width, that is, the horizontal width of the groove portion 24a, is substantially the same as or slightly greater than the thickness of the fin 32 of the fin unit 30.

As illustrated in FIG. 2, tip portions of the fins 32 corresponding to the groove portions 24a can be inserted respectively into the groove portions 24a. An inner wall surface of the groove portion 24a is in contact with the tip portion. In other words, the covering portion 24 covers the fin unit 30 in a state in which the covering portion 24 is thermally connected with the fins 32 included in the fin unit 30.

A plurality of guide portions 24b is formed in the covering portion 24. The guide portion 24b is formed in a manner in which the width of the guide portion 24b in the horizontal direction (a direction perpendicular to the longitudinal direction of the groove portion 24a) gradually reduces toward the front (toward the base end portion of the fin 32) between the groove portions 24a adjacent to each other. The guide portion 24b has an inclined surface 24c continuing to the inner wall surface of the groove portion 24a. In the present embodiment, the guide portion 24b is formed also on the left side of the groove portion 24a that is located leftmost and on the right side of the groove portion 24a that is located rightmost.

According to the electric power conversion device having the configuration as described above, not only the fin unit 30 that forms the heat sink but also the frame 20 is formed of the highly heat-conductive material and the covering portion 24 of the frame 20 covers the fin unit 30 in a state in which the covering portion 24 is thermally connected with the fins 32 included in the fin unit 30. Therefore, the entire frame 20 including the covering portion 24 plays a role of a heat dissipation member, and thereby a heat dissipation area is increased, so that it is possible to improve the cooling efficiency.

According to the electric power conversion device described above, at least the guide portion 24b having an inclined surface 24c continuing to the inner wall surface of the groove portion 24a is formed between the groove portions 24a adjacent to each other, so that when the fin 32 of the fin unit 30 is inserted into a corresponding groove portion 24a, the inclined surface 24c of the guide portion 24b can play a role of a guide surface that guides the tip portion of the fin 32 into the groove portion 24a. Thereby, it is possible to smoothly insert the tip portion of each fin 32 into a corresponding groove portion 24a.

According to the electric power conversion device described above, unevenness is also formed on the surfaces of the side surface portions 22 and 23 included in the frame 20, so that it is possible to increase the heat dissipation area by increasing the surface areas of the side surface portions 22 and 23. Thereby, it is also possible to improve the cooling efficiency.

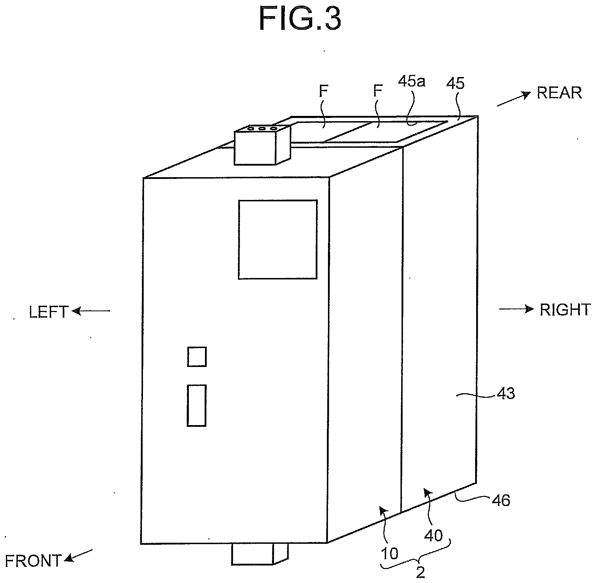

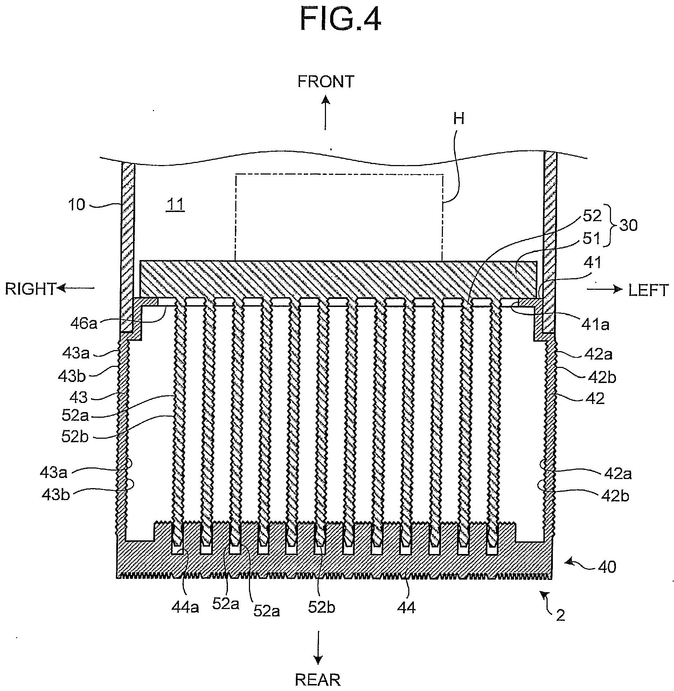

FIG. 3 is a perspective view schematically illustrating a modified example of the electric power conversion device which is the embodiment of the present invention. FIG. 4 is a cross-sectional view illustrating an enlarged main portion of the electric power conversion device illustrated in FIG. 3. The same components as those of the electric power conversion device which is the embodiment described above will be denoted by the same reference numerals, and redundant description will be appropriately omitted.

The electric power conversion device exemplified here includes an device main body 2. The device main body 2 is configured to include a storage main body 10 and a frame 40.

The frame 40 is formed by, for example, extrusion molding of a highly heat-conductive material having good thermal conductivity such as, for example, aluminum. The frame 40 is a cylindrical body where a front surface portion 41 which is covered by the storage main body 10 and which faces inside the storage main body 10, a pair of left and right side surface portions 42 and 43 which extends from both left and right end portions of the front surface portion 41 toward the rear, and a covering portion 44 which connects respective rear end portions of the side surface portions 42 and 43 are integrally formed, so that ventilating openings 45a and 46a through which external air passes are formed in an upper surface 45 and a lower surface 46.

The ventilating opening 45a in the upper surface 45 is closed by arranging a plurality of blower fans F supported by the frame 40. Here, when the blower fan F is driven, the blower fan F introduces external air from the ventilating opening 46a formed in the lower surface 46 into the inside of the frame 40 and transmits the air that passes through the inside of the frame 40 to the outside through the ventilating opening 45a formed in the upper surface 45. The ventilating opening 46a in the lower surface 46 is appropriately covered by a filter or the like not illustrated in the drawings.

A fin unit 50 which is a heat sink is arranged to the frame 40. The fin unit 50 is formed by, for example, extrusion molding of a highly heat-conductive material having good thermal conductivity such as, for example, aluminum. The fin unit 50 includes a base portion 51 and a plurality of fins 52.

The base portion 51 has a substantially flat plate shape and is attached to the front surface portion 41 of the frame 40. A semiconductor element H such as, for example, an IGBT (Insulated Gate Bipolar Transistor), a MOS-FET (Metal Oxide Semiconductor-Field Effect Transistor), and a diode is thermally connected to the front surface of the base portion 51. Here, the semiconductor element H may be not only a Si-based semiconductor, but also a wide band gap semiconductor element composed mainly of at least one material selected from silicon carbide, gallium nitride, and diamond.

The plurality of fins 52 is formed so as to penetrate an attaching opening 41a formed in the front surface portion 41 of the frame 40 and protrude from the rear surface of the base portion 51 toward the rear. Further, the fins 52 are formed so as to be arranged at predetermined intervals along the horizontal direction.

An inclined guide surface 52a is formed at a tip portion of each fin 52. The inclined guide surface 52a is formed by gradually reducing the thickness of the fin 52 toward a tip surface 52b of the fin 52. On the surface of the fin 52 from the tip portion to the base end portion, unevenness is formed by alternately forming recessed portions 52c and protruded portions 52d.

On the left side surface portion 42 of the frame 40, unevenness is formed by alternately forming recessed portions 42a and protruded portions 42b on a left surface that is an outer surface and on a right surface that is an inner surface. Further, on the right side surface portion 43 of the frame 40, unevenness is formed by alternately forming recessed portions 43a and protruded portions 43b on a right surface that is an outer surface and on a left surface that is an inner surface.

The covering portion 44 of the frame 40 forms a rear surface portion of the frame 40. A plurality of groove portions 44a is formed in a front surface of the covering portion 44. The groove portions 44a extend in the front surface of the covering portion 44 in the vertical direction. The groove width, that is, the horizontal width of the groove portion 44a, is substantially the same as the maximum width in the thickness direction of the fin 52 of the fin unit 50.

As illustrated in FIG. 3, tip portions of the fins 52 corresponding to the groove portions 44a can be inserted respectively into the groove portions 44a. An inner wall surface of the groove portion 44a is in contact with the tip portion. In other words, the covering portion 44 covers the fin unit 50 in a state in which the covering portion 44 is thermally connected with the fins 52 included in the fin unit 50. In the covering portion 44, unevenness is formed on the rear surface and on the front surface except for regions where the groove portions 44a are formed.

According to the electric power conversion device having the configuration as described above, not only the fin unit 50 that forms the heat sink but also the frame 40 is formed of the highly heat-conductive material and the covering portion 44 of the frame 40 covers the fin unit 50 in a state in which the covering portion 44 is thermally connected with the fins 52 included in the fin unit 50. Therefore, the entire frame 40 including the covering portion 44 plays a role of a heat dissipation member, and thereby a heat dissipation area is increased, so that it is possible to improve the cooling efficiency.

According to the electric power conversion device described above, the inclined guide surface 52a is formed at the tip portion of each fin 52, so that when the fin 52 of the fin unit 50 is inserted into a corresponding groove portion 44a, the inclined guide surface 52a slidably contacts a front edge portion of the groove portion 44a, and thereby the inclined guide surface 52a can play a role of a guide surface that guides the tip portion of the fin 52 into the groove portion 44a. Thereby, it is possible to smoothly insert the tip portion of each fin 52 into a corresponding groove portion 44a.

According to the electric power conversion device described above, unevenness is also formed on the surfaces of the side surface portions 42 and 43 included in the frame 40, so that it is possible to increase the heat dissipation area by increasing the surface areas of the side surface portions 42 and 43. Thereby, it is also possible to improve the cooling efficiency.

While the preferred embodiment of the present invention and its modified example have been described, the present invention is not limited thereto, but can be variously modified.

In other words, in the present invention, the shape or the like of the frame is not particularly limited as long as the frame is thermally connected with the tip portion of the fin and includes a covering portion that covers the heat sink.

### Reference Signs List

- 1: DEVICE MAIN BODY

- 10: STORAGE MAIN BODY
- 20: FRAME
- 22: SIDE SURFACE PORTION
- 23: SIDE SURFACE PORTION
- 24: COVERING PORTION
- 24A: GROOVE PORTION
- 24B: GUIDE PORTION
- 24C: INCLINED SURFACE
- 25A: VENTILATING OPENING
- 26A: VENTILATING OPENING
- 30: FIN UNIT
- 31: BASE PORTION
- 32: FIN
- H: SEMICONDUCTOR ELEMENT

## Claims

1. An electric power conversion device comprising:
a frame which is formed of a highly heat-conductive material, the frame being provided with a heat sink that dissipates heat of a semiconductor element stored inside an device main body, the frame being provided with an opening that causes external air to pass through between fins included in the heat sink,
wherein the frame includes a covering portion that covers the heat sink in a state in which the frame is thermally connected to each fin by inserting a tip portion of each fin into a groove portion formed in the covering portion.

2. The electric power conversion device according to claim 1, wherein the covering portion includes at least a guide portion which is formed in a manner in which a width of the guide portion in a direction perpendicular to a longitudinal direction of the groove portion gradually reduces toward a base end portion of the fin between groove portions adjacent to each other and which has an inclined surface continuing to an inner wall surface of the groove portion.

3. The electric power conversion device according to claim 1, wherein the fin includes an inclined guide surface formed by gradually reducing a thickness of the fin toward a tip surface of the fin.

4. The electric power conversion device according to claim 1, wherein the frame has a surface with unevenness.

5. The electric power conversion device according to any one of claims 1 to 4, wherein the semiconductor element is a wide band gap semiconductor element composed mainly of at least one material selected from silicon carbide, gallium nitride, and diamond.
